# FASCICULE DE BREVET EUROPEEN

(11) **EP 0 425 841 B1**
(45) Date de publication et mention de la délivrance du brevet: **16.03.1994**
(21) Numéro de dépôt: 90119250.0
(22) Date de dépôt: 08.10.1990
(51) Int. Cl.: H05K 7/20

(54) **Assemblage de composants en électronique de puissance**
Anordnung von elektronischen Leistungsbauelementen
Assembly of electronic power components

(30) Priorité: 11.10.1989 FR 8913278
(43) Date de publication de la demande: 08.05.1991
(73) Titulaire: GEC ALSTHOM SA, 75116 Paris (FR)
(72) Inventeur: Chave, Jacques, F-69003 Lyon (FR)
(74) Mandataire: Weinmiller, Jürgen

(56) Documents cités:
- DE-A- 3 630 830
- DE-U- 8 811 949
- FR-A- 2 128 620

## Description

La présente invention concerne les circuits hybrides de puissance, et plus particulièrement la commande à bas niveaux des composants électroniques de puissance formant ces circuits.

Afin de dissiper et d'évacuer la chaleur produite par un circuit hybride de puissance en fonctionnement, il est connu de braser ce circuit sur une semelle dissipatrice thermique, généralement en cuivre, elle même fixée à un radiateur.

Ce problème de dissipation et d'évacuation thermique se posant de façon moins critique pour les circuits électroniques de commande à bas niveaux, il est par ailleurs connu, pour obtenir des ensembles plus compacts, de disposer ces circuits de commande en étage sur le circuit hybride de puissance, ledit étage étant généralement constitué d'un circuit imprimé relié électriquement au circuit hybride de puissance.

Il reste cependant que la chaleur produite par les circuits de commande en fonctionnement n'est pas négligeable, et qu'un fonctionnement correct de l'ensemble n'est donc pas garanti.

Le FR-A-2128620 décrit un circuit électrique ayant au moins un composant de circuit électronique générateur de chaleur indésirée et d'autres composants électroniques du circuit qui sont sensibles à la chaleur. Un agencement pour accroître la puissance et les capacités de fonctionnement à la température du circuit comporte un premier élément conducteur de la chaleur supportant le composant générateur de chaleur et fournissant une faible résistance thermique entre ce composant et le milieu ambiant, cet élément ayant une surface de transfert de chaleur externe, un deuxième élément supportant les composants sensibles à la chaleur et fournissant une surface de transfert de chaleur externe et un dispositif reliant le premier et le deuxième élément et établissant entre eux, une résistance thermique relativement élevée.

La présente invention a pour objet une solution permettant de conserver l'emplacement en étage de la partie commande à bas niveaux d'un circuit hybride de puissance, tout en assurant un refroidissement efficace de celle-ci, sous un encombrement minimum, inférieur à celui nécessité classiquement pour le refroidissement d'un circuit hybride et rappelé ci-dessus.

Suivant l'invention, cet assemblage de composants en électronique de puissance, comportant des circuits électroniques de commande à bas niveaux montés en étage sur des circuits électroniques de puissance réalisés en circuit hybride, est essentiellement caractérisé en ce que les circuits électroniques de commande à bas niveaux sont également réalisés en circuit hybride, sur un substrat en nitrure d'aluminium.

D'autres objets et caractéristiques de la présente invention apparaîtront plus clairement à la lecture de la description suivante d'exemples de réalisation, faite en relation avec les dessins ci-annexés dans lesquels:
- la figure 1 est un schéma d'un premier mode de réalisation de l'invention ;
- la figure 2 est un schéma d'un deuxième mode de réalisation de l'invention.

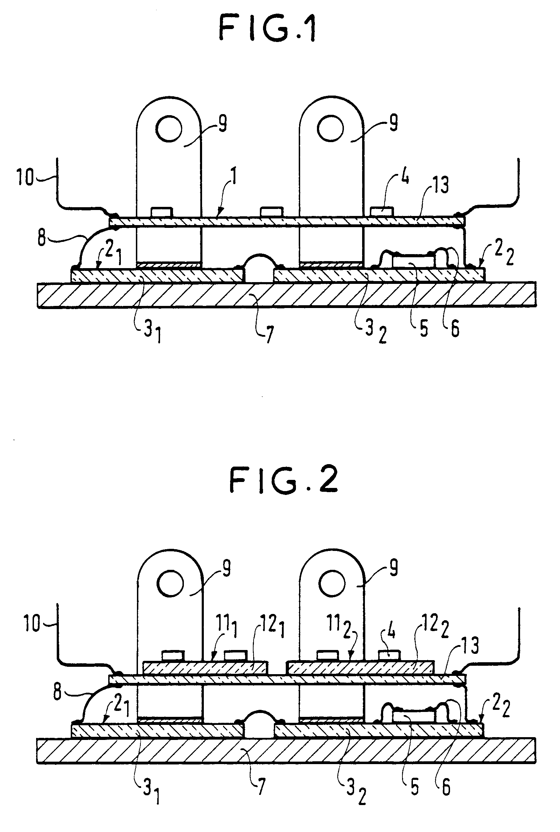

Les figures 1 et 2 sont des vues en coupe transversale d'assemblages de composants suivant l'invention. On distingue sur ces figures, en dessous d'un étage 1 portant des circuits électroniques de commande à bas niveaux, un circuit hybride de puissance 2 constitué en l'occurence de circuits hybrides élémentaires tels que 2₁ et 2₂ portant des circuits électroniques de puissance sérigraphiés sur un substrat 3 (respectivement 31, 32). Seuls sont visibles sur ces vues en coupe les composants électroniques, tels que 4 et 5, formant respectivement les circuits électroniques de commande et les circuits électroniques des puissance. Sont également visibles les fils de liaison tels que 6 (connus sous le terme anglo saxon de "bondings") raccordant les plots de connexion de composants actifs des circuits électroniques de puissance à des plots de connexion correspondants du substrat 3.
Le substrat 3, réalisé dans un matériau classique tel que l'alumine, est brasé à une semelle dissipatrice thermique 7.

L'étage de commande est également réalisé en circuit hybride, mais ne pouvant, pour des raisons d'encombrement, être fixé à une semelle dissipatrice thermique, est réalisé sur un substrat en nitrure d'aluminium, présentant une très bonne conductivité thermique.

L'évacuation des calories est alors obtenue en reliant, par des drains thermiques tels que 8, le substrat en nitrure d'aluminium à la semelle dissipatrice thermique ou à des broches 9 de connexion du circuit hybride de puissance avec des éléments extérieurs à cet assemblage.

Ces broches de connexion et drains thermiques peuvent également servir de support pour l'étage de commande.

Le circuit hybride de commande est également muni de broches telles que 10, de connexion à des éléments extérieurs à cet assemblage.

Dans le mode de réalisation représenté sur la figure 1, les circuits de commande sont entièrement sérigraphiés sur le substrat en nitrure d'aluminium, alors que dans le mode de réalisation représenté sur la figure 2, seuls sont sérigraphiés sur ce substrat en nitrure d'aluminium des pistes d'interconnexion de circuits hybrides élémentaires, tels que 11₁ et 11₂, réalisés sur substrat, respectivement 12₁ et 12₂, en alumine, et brasés au substrat en nitrure d'aluminium 13 sur lequel sont prévus à cet effet des plages de soudure.

## Revendications

1. Assemblage de composants en électronique de puissance, comportant des circuits électroniques de commande à bas niveaux montés en étage (1) sur des circuits électroniques de puissance réalisés en circuit hybride (2), caractérisé en ce que les circuits électroniques de commande à bas niveaux sont également réalisés en circuit hybride, sur un substrat en nitrure d'aluminium.

2. Assemblage selon la revendication 1, caractérisé en ce que le substrat du circuit hybride de puissance étant fixé à une semelle dissipatrice thermique (7), ledit substrat en nitrure d'aluminium est relié à ladite semelle dissipatrice thermique par l'intermédiaire de drains thermiques (8).

3. Assemblage selon la revendication 1, caractérisé en ce que, le substrat du circuit hybride de puissance étant fixé à une semelle dissipatrice thermique (7), ledit substrat en nitrure d'aluminium est relié à ladite semelle dissipatrice thermique par l'intermédiaire de broches (9) de connexion du circuit hybride de puissance à des éléments extérieurs à ce circuit.

4. Assemblage selon l'une des revendications 1 à 3, caractérisé en ce que les circuits électroniques de commande sont directement sérigraphiés sur le substrat en nitrure d'aluminium.

## Patentansprüche

1. Aufbau von elektronischen Leistungsbauelementen, mit leistungsarmen elektronischen Steuerschaltungen, die stufenartig (1) auf elektronische Leistungskreise aufgesetzt sind, die als Hybridkreise (2) ausgebildet sind, dadurch gekennzeichnet, daß die leistungsarmen elektronischen Steuerschaltungen ebenfalls als Hybridkreise auf einem Substrat aus Aluminiumnitrid ausgebildet sind.

2. Aufbau nach Anspruch 1, dadurch gekennzeichnet, daß das Substrat des hybriden Leistungskreises auf einer wärmeabstrahlenden Sohle (7) befestigt ist, während das Substrat aus Aluminiumnitrid mit dieser wärmeabstrahlenden Sohle über Wärmeableiter (8) verbunden ist.

3. Aufbau nach Anspruch 1, dadurch gekennzeichnet, daß das Substrat des hybriden Leistungskreises auf einer wärmeabstrahlenden Sohle (7) befestigt ist, während das Substrat aus Aluminiumnitrid mit dieser wärmeabstrahlenden Sohle über Verbindungsklemmen (9) zwischen dem hybriden Leistungskreis und außerhalb dieses Kreises liegenden Elementen verbunden ist.

4. Aufbau nach einem der Ansprüche 1 bis 3, dadurch gekennzeichnet, daß die elektronischen Steuerschaltungen direkt durch Siebdruck auf das Substrat aus Aluminiumnitrid aufgebracht sind.

## Claims

1. An electronic power component circuit comprising low level electronic control circuits mounted on a platform (1) over electronic power circuits constituted as a hybrid circuit (2), characterized in that the low level electronic control circuits are also constituted as a hybrid circuit, being formed on a substrate of aluminum nitride.

2. A circuit according to claim 1, characterized in that the hybrid power circuit is fixed to a heat dissipating slab (7), and said aluminum nitride substrate is connected to said heat dissipating slab via heat drains (8).

3. A circuit according to claim 1, characterized in that the hybrid power circuit substrate is fixed to a heat dissipating slab (7) and said aluminum nitride substrate is connected to said heat dissipating slab via brackets (9) for connecting the hybrid power circuit to items external thereto.

4. A circuit according to claim 1, 2, or 3, characterized in that the electronic control circuits are printed on the aluminum nitride substrate directly.
